# EUROPEAN PATENT APPLICATION

(11) **EP 0 978 845 A1**
(43) Date of publication of application: **09.02.2000**
(21) Application number: 98830490.3
(22) Date of filing: 07.08.1998
(51) Int. Cl.: G11C 16/04

(54) **Electrically programmable non-volatile semiconductor memory**

(71) Applicant: STMicroelectronics S.r.l., 20041 Agrate Brianza (Milano) (IT)
(72) Inventor: Caprara, Paolo, 20162 Milano (IT)
(74) Representative: Mittler, Enrico

(57) **Abstract**

Electrically programmable non-volatile memory device, comprising an array (1) of memory cells (MC) arranged in rows (WLₙ-WLₙ₊₃) and columns (BLₙ-BLₙ₊₄) with common source diffusions (SD) contacted by at least one conductive matrix source line (SLₙ,SLₙ₊₁) coupled to an external source bias voltage conductor (SELsource) external to the memory cell array carrying a voltage to be applied to source regions of the memory cells in the memory cell array. At least one resistive means (10) is connected in series between the at least one matrix source line and the external source bias voltage conductor, the resistive means being external to the memory cell array and being suitable to cause a rise in a voltage of the source regions of the memory cells when run through by a memory cell programming current during a programming operation of the memory device.

## Description

The present invention relates to non-volatile semiconductor memories. More particularly, the invention relates to electrically programmable non-volatile semiconductor memories such as EPROMs and Flash EEPROMs.

Conventionally, non-volatile semiconductor memories comprise an array of memory cells arranged in rows and columns. Each memory cell comprises a floating-gate MOS transistor having a drain region connected to a respective column, a control gate connected to a respective row, a floating gate electrically insulated from the control gate for storing charges, and a source region. In EPROM devices, the source regions of all the memory cells of the array are electrically connected to each other, and to a ground potential. In Flash EEPROM devices, the array is often divided in sub-arrays or memory sectors, and the source regions of all the memory cells of a memory sector are connected to each other and to a line whose voltage can be switched between ground and a positive potential in the erase operation.

As known, EPROMs and Flash EEPROMs are electrically programmable memory devices. The programming technique is similar in the two kinds of devices: a high positive voltage is applied to the control gate and drain region of the memory cell, while the source region is kept to ground. A significant current flows through the memory cell. Hot electrons which are generated at the drain side jump from the drain region to the floating gate, where they remain trapped. Thus, programming is achieved by means of hot-electron injection.

The main problems encountered in scaling down the size of the memory cells are due to parasitic effects such as punch-through, drain turn-on, snap-back, drain stress and source stress.

Punch-through is the setting-up of a leakage current between the source and drain regions of the memory cell due to the lowering of the potential barrier at the source region in consequence of the voltage applied to the drain region.

Drain turn-on refers to the memory cell turning on, i.e. the formation of a conductive channel under the floating gate, in consequence of a voltage being applied to the drain region, due to the capacitive coupling between the drain region and the floating gate.

Snap-back is the triggering on of a parasitic bipolar transistor inherently associated with the memory cell, and having emitter, base and collector respectively formed by the source region, the semiconductor substrate and the drain region of the memory cell.

Drain stress and source stress refer to the carrier multiplication effect caused by the high doping level of the source and drain regions.

These problems can be individually faced and solved by acting on, e.g., the memory cell channel doping level and effective length.

For example, in order to solve the problems of punch-through and drain turn-on, specific modifications to the manufacturing process have been devised. Such modifications provide for the formation of a so-called "P pocket" (LArge Tilt Implanted Drain or LATID): the drain region of the memory cell is formed by means of a tilted implantation of dopants, so as to form a memory cell substantially equivalent to the series of two MOS transistors. Of these two MOS transistors, the one undergoing the LATID implant (drain side) has a rather high threshold voltage but a short channel. Consequently, this high-threshold, short-channel MOS transistor has a negligible impact on the overall threshold voltage of the memory cell and does not affect the cell current during reading, which is essential from the viewpoint of the memory device access time; in addition, being the drain region quite highly doped, the depletion region at the drain does not extend significantly into the channel of the memory cell. The high doping level of the drain region also positively impacts the programming efficiency of the memory cell, thanks to the high electric field at the drain. Finally, drain turn-on is also reduced, since the depletion region at the drain does not extend significantly into the channel and the capacitive coupling between the drain region and the floating gate is consequently reduced.

However, the LATID technique alone shows some drawbacks. First, this technique does not solve the problem of snap-back. Second, the drain stress problem is exacerbated, due to the high doping level of the drain region. Third, the LATID technique is not simple to be practically implemented and industrially reproduced.

In view of the state of the art described, it has been an object of the present invention to provide an electrically programmable non-volatile memory device resolving the above-referred problems.

According to the present invention, such an object has been achieved by means of an electrically programmable non-volatile memory device, comprising an array of memory cells arranged in rows and columns with common source diffusions contacted by at least one conductive matrix source line coupled to an external source bias voltage conductor external to the memory cell array carrying a voltage to be applied to source regions of the memory cells in the memory cell array, characterized in that at least one resistive means is connected in series between said at least one matrix source line and the external source bias voltage conductor, the resistive means being external to the memory cell array and being suitable to cause a rise in a voltage of the source regions of the memory cells when run through by a memory cell programming current during a programming operation of the memory device.

The features and advantages of the present invention will be made more evident by the following detailed description of one practical embodiment thereof, illustrated by way of a non-limiting example in the annexed drawings, wherein:
Figure 1 is a schematic circuit diagram of an electrically-programmable non-volatile semiconductor memory device according to a first embodiment of the invention;
Figure 2 is a layout view of a portion of a memory cell array of the memory device of Figure 1; and
Figure 3 is a schematic circuit diagram of an electrically programmable non-volatile semiconductor memory device according to a second embodiment of the invention.

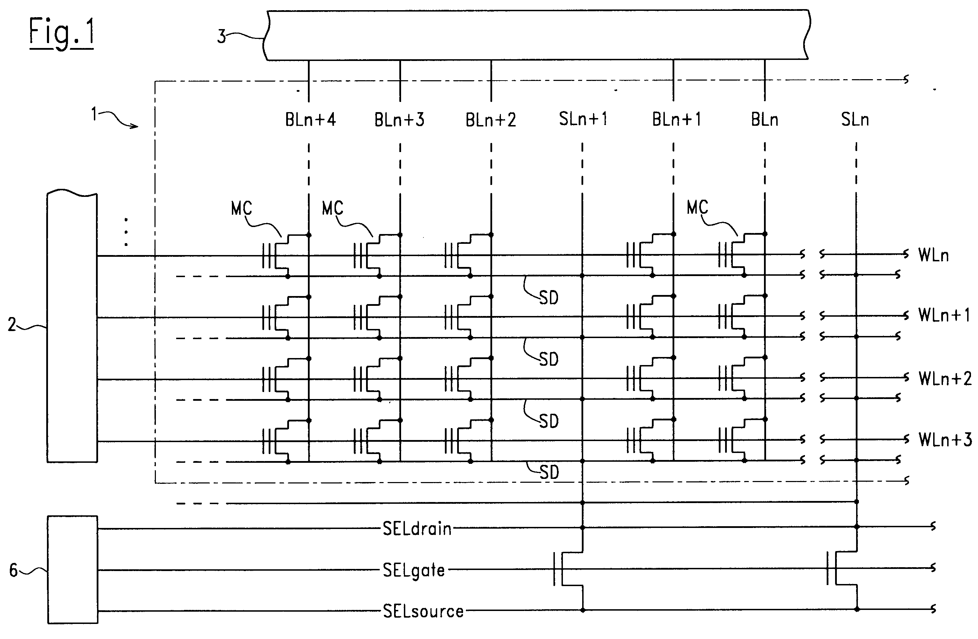

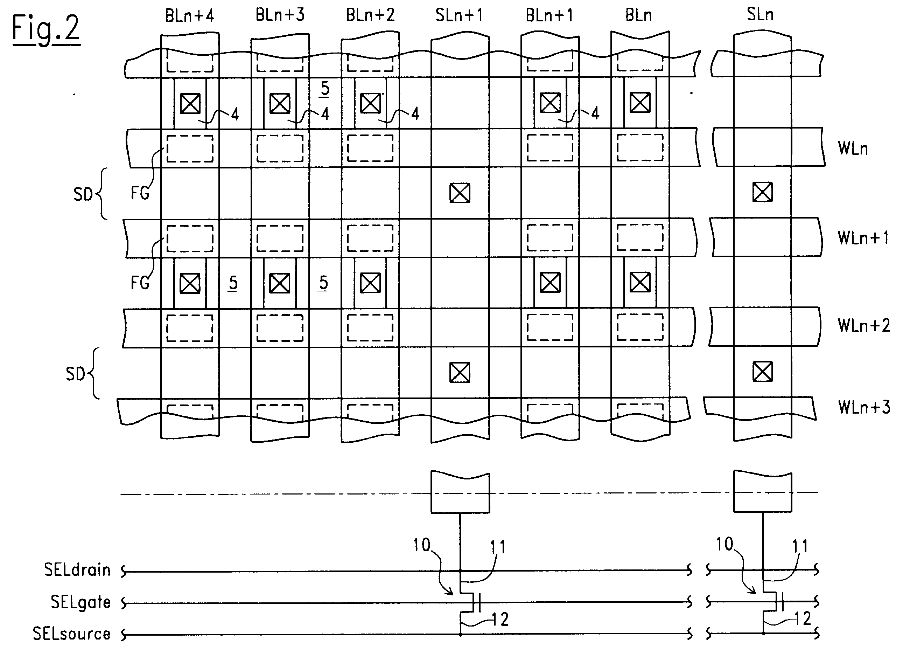

With reference to Figures 1 and 2, an electrically-programmable non-volatile memory device generally comprises an array 1 of memory cells MC, arranged in rows (word lines) WLₙ - WLₙ₊₃ and columns (bit lines) BLₙ -BLₙ₊₄. Each memory cell MC conventionally comprises a floating gate MOS transistor having a drain region connected to a respective bit line, a control gate connected to a respective word line, an electrically isolated floating gate, and a source region connected to one of a plurality of source diffusions SD. A row decoder 2 and a column decoder 3 are conventionally provided for selecting the rows and the columns of the memory array. As better seen in Figure 2, the word lines WLₙ - WLₙ₊₃ are substantially parallel strips made from an upper polysilicon level and run in a first direction. The bit lines BLₙ - BLₙ₊₄ are substantially parallel strips made from a metal layer and run in a second direction, orthogonal to that of the word lines. The drain regions of the memory cells are formed by doped semiconductor regions 4, e.g. N+ regions, formed in a P type semiconductor substrate. A plurality of drain regions 4 are formed between alternate pairs of word lines, and are separated from each other by field oxide regions 5. The bit lines contact the drain regions 4. At the crossings between the word lines and the bit lines, floating gates FG are formed from a lower polysilicon level under the word lines. The source diffusions SD are for example N+ doped semiconductor stripes formed in the semiconductor substrate between alternate pairs of word lines, and run parallely to the word lines. Matrix source lines SLₙ, SLₙ₊₁ made from a metal layer are interspersed between and run parallelly to the bit lines. The matrix source lines SLₙ, SLₙ₊₁ contact the source diffusions SD.

According to one embodiment of the present invention, a resistive element 10, placed externally to the memory cell array, is connected in series between each matrix source line SLₙ, SLₙ₊₁ and a source bias voltage conductor SELsource external to the memory cell array. The resistive element 10 has a resistance which cause an increase of the voltage of the respective matrix source line SLₙ, SLₙ₊₁ which depends on the current passing through the said source line. In particular, the resistive element's resistance is such that substantially no increase in the voltage of the source line takes place in reading condition of the memory device, while such a voltage increase takes place when the source line is run through by a programming current, i.e. during a programming operation of the memory device.

Advantageously, the resistive element can be formed as a conventional MOSFET, with a drain region 11 connected to the respective matrix source line, a source region 12 connected to the source bias voltage conductor SELsource, and a gate electrode connected to a respective selection line SELgate. If necessary, the drain electrode of the MOSFET 10 can be connected to a drain selection line SELdrain. Lines SELdrain, SELgate and SELsource are schematically represented to be controlled by a control circuit 6. In the case of an EPROM device, line SELsource can be constantly kept connected to the ground potential. Differently, in a Flash EEPROM device it is necessary to switch line SELsource between ground, in reading and programming conditions, and a positive voltage in erase condition. Alternatively, for a Flash EEPROM in erase operation, the MOSFET 10 can be kept off, and the required positive voltage can be applied directly to line SELdrain.

The MOSFET 10 has to be properly dimensioned, i.e. its channel length and width should be chosen according to the current that can flow through the respective matrix source line, so to achieve the desired resistance. More specifically, the MOSFET 10 should be sufficiently conductive in reading conditions, when the current flowing through the matrix source line is low: this in order to avoid a rise in the source potential of the memory cells to be read, which would negatively affect the memory cell current and so the access time of the memory device. However, during programming, the current flowing through the matrix source line is quite high, and this produce a rise in the potential of the matrix source line; the source regions of the memory cells to be programmed are thus no more at the ground voltage, but at a voltage which is higher the higher the current flowing through the matrix source line. Thus, the provision of the resistive element introduces a sort of negative feedback.

The resistive element, e.g. the MOSFET 10, behaves in respect of the snap-back and punch-through effects as a long-channel MOSFET. During programming, snap-back of the memory cells is prevented by the fact that when the current flowing through the memory cell becomes too high the node corresponding to the source region of the cell rises in potential with respect to ground; in this way, the reverse bias applied to the junction source/substrate increases, and this totally eliminates the snap-back effect, which as known is due to the forward biasing of the source/substrate junction caused by carriers which are generated by avalanche effect at the drain in programming conditions. The effect on the punch-through problem is totally similar.

The present invention has several advantages. First, it makes possible to reduce the length of the gate electrode, and thus the overall size, of the memory cells. Second, the punch-through and snap-back effects are eliminated. Third, it allows to eliminate the short-channel effects, so the doping level of the memory cell channel can be reduced; this in turn has the following advantages: the memory cell threshold voltage is reduced, and the cell current for low voltage reading is therefore increased; the drain-stress and source stress effects are reduced. Additionally, especially in Flash EEPROM devices, band-to-band tunnelling is reduced, and junction breakdown voltage increased.

Instead of a simple MOSFET, any other resistive means can be used. The use of a MOSFET has the advantage that its resistance can be modulated by acting on the gate-to-source voltage thereof, i.e. for example acting on the voltage of line SELgate.

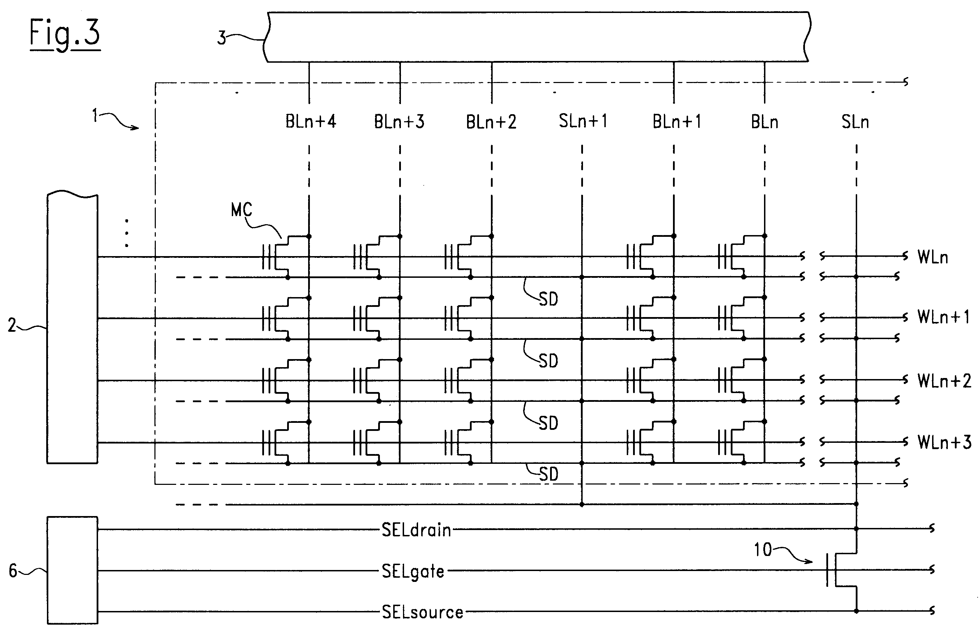

In another embodiment, shown in Figure 3, only one resistive element 10, in the example again represented by a simple MOSFET, can be connected in series to all the matrix source lines. This is for example suitable for EPROM devices, which normally do not comprise memory sectors. In the case of Flash EEPROMs with memory sectors, one resistive element 10 can be provided for each memory sector, with respective lines SELdrain, SELgate and SELsource independent from those of the other memory sectors.

Clearly, mixed arrangements are also possible, wherein groups of matrix source lines of a memory matrix or memory sector are connected to a same resistive element.

The present invention, providing for one or more resistive elements which are placed externally to the memory matrix or memory sector is simple to be implemented and also gives much flexibility: the resistive element or elements can be modified by simply changing few masks, and in any case without affecting the memory matrix area.

Additionally, the fact that the resistive element or elements are external to the memory matrix has the advantage of making the same easily controllable, as in the shown examples where MOSFETs 10 can be easily controlled by lines SELdrain, SELgate and SELsource. Obviously, this would not be the case were the resistive element or elements be placed inside of the memory array.

## Claims

1. Electrically programmable non-volatile memory device, comprising an array (1) of memory cells (MC) arranged in rows (WLₙ-WLₙ₊₃) and columns (BLₙ-BLₙ₊₄) with common source diffusions (SD) contacted by at least one conductive matrix source line (SLₙ,SLₙ₊₁) coupled to an external source bias voltage conductor (SELsource) external to the memory cell array carrying a voltage to be applied to source regions of the memory cells in the memory cell array, characterized in that at least one resistive means (10) is connected in series between said at least one matrix source line and the external source bias voltage conductor, the resistive means being external to the memory cell array and being suitable to cause a rise in a voltage of the source regions of the memory cells when run through by a memory cell programming current during a programming operation of the memory device.

2. Electrically programmable non-volatile memory device according to claim 1, characterized in that said at least one resistive means (10) comprises a MOSFET.

3. Electrically programmable non-volatile memory device according to claim 2, characterized by comprising driving means (6) for driving said MOSFET (10) so that the resistive means has different resistive values depending on the operating condition of the memory device.

4. Electrically programmable non-volatile memory device according to claim 1 or 2, characterized in that said at least one matrix source line (SLₙ,SLₙ₊₁) comprises a plurality of matrix source lines interspersed among said columns (BLₙ-BLₙ₊₄).

5. Electrically programmable non-volatile memory device according to claim 3, characterized by providing a single resistive means (10) connected in series between said plurality of matrix source lines (SLₙ,SLₙ₊₁) and said external source bias voltage conductor (SELsource).

6. Electrically programmable non-volatile memory device according to claim 3, characterized by providing a plurality of resistive means (10), each one connected in series between a respective matrix source line (SLₙ,SLₙ₊₁) and the external source bias voltage conductor (SELsource).

7. Electrically programmable non-volatile memory device according to anyone of the preceding claims, characterized in that said memory cell array (1) comprises a plurality of memory sectors, each memory sector having associated therewith at least one resistive means (10).

8. Electrically programmable memory device according to anyone of the preceding claims, characterized in that said memory cells (MC) are EPROM cells.

9. Electrically programmable memory device according to anyone of claims 1 to 7, characterized in that said memory cells (MC) are Flash EEPROM cells.
